# EUROPEAN PATENT APPLICATION

(11) **EP 4 350 362 A1**
(43) Date of publication of application: **10.04.2024**
(21) Application number: 22811226.4
(22) Date of filing: 18.05.2022
(51) Int. Cl.: G01R 1/067, G01R 1/073

(54) **PROBE**

(30) Priority: 28.05.2021 JP 2021090381
(71) Applicant: Kabushiki Kaisha Nihon Micronics, Musashino-shi, Tokyo 180-8508 (JP)
(72) Inventor: UMEDA Ryuichi, Musashino-shi, Tokyo 180-8508 (JP); TOKUMARU Koichiro, Musashino-shi, Tokyo 180-8508 (JP); MURAMOTO Tsuyoshi, Musashino-shi, Tokyo 180-8508 (JP)
(74) Representative: Samson & Partner Patentanwälte mbB
(86) International application number: PCT/JP2022/020702
(87) International publication number: WO 2022/249954

(57) **Abstract**

A probe includes a first tip and a second tip, and a body part connecting the first tip and the second tip. The body part includes a first end connected to the first tip, a second end connected to the second tip, a columnar first arm and a columnar second arm arranged in parallel and spaced apart from each other between the first end and the second end, and a spacing component that is interposed between the first arm and the second arm.

## Description

### TECHNICAL FIELD

The present invention relates to a probe that is used for inspecting the electrical characteristics of an inspection object.

### BACKGROUND ART

In order to inspect the electrical characteristics of an inspection object, such as a semiconductor integrated circuit, in a state in which the inspection object is not separated from the wafer, a probe that comes in contact with the inspection object is used. In the inspection using a probe, a method may be used in which a load is applied to the probe such that the probe in contact with the inspection object deforms elastically. Since the probe is elastically deformed, the probe reliably comes in contact with the inspection object due to the elastic force of the probe. In order to adjust the pressing force of a probe that comes in contact with an inspection object, a probe has been studied having a structure in which a plurality of columnar arms are arranged in parallel (see Patent Literature 1).

### CITATION LIST

### PATENT LITERATURE

US Patent No. 10,578,646

### SUMMARY OF THE INVENTION

### TECHNICAL PROBLEM

However, when a load is applied to the probe having the structure in which the plurality of arms are arranged in parallel, by bringing the probe into contact with the inspection object, the distance between the arms increases or decreases. This causes short-circuiting between adjacent probes or plastic deformation of the probe due to bending of the arms.

An object of the present invention is to provide a probe that suppresses short-circuiting between adjacent probes and plastic deformation of the probe.

### TECHNICAL SOLUTION

A probe according to an aspect of the present invention includes a first tip and a second tip, and a body part connecting the first tip and the second tip. The body part includes a first end connected to the first tip, a second end connected to the second tip, a columnar first arm and a columnar second arm arranged in parallel and spaced apart from each other between the first end and the second end, and a spacing component that is interposed between the first arm and the second arm.

### ADVANTAGEOUS EFFECT OF THE INVENTION

The present invention makes it possible to provide a probe that suppresses short-circuiting between adjacent probes and plastic deformation of the probe.

### BRIEF DESCRIPTION OF THE DRAWINGS

[FIG. 1] FIG. 1 is a schematic diagram illustrating a configuration of a probe according to a first embodiment of the present invention.
[FIG. 2] FIG. 2 is a schematic diagram illustrating a configuration of a probe card having the probe according to the first embodiment of the present invention.
[FIG. 3A] FIG. 3A is a schematic diagram illustrating another configuration of the probe according to the first embodiment of the present invention.
[FIG. 3B] FIG. 3B is a schematic diagram illustrating yet another configuration of the probe according to the first embodiment of the present invention.
[FIG. 4] FIG. 4 is a schematic diagram illustrating a configuration of a probe according to a modified example of the first embodiment of the present invention.
[FIG. 5] FIG. 5 is a schematic diagram illustrating a configuration of a probe according to another modified example of the first embodiment of the present invention.
[FIG. 6] FIG. 6 is a schematic diagram illustrating a configuration of a probe according to a second embodiment of the present invention.
[FIG. 7] FIG. 7 is a schematic diagram illustrating a state in which a load is applied to the probe illustrated in FIG. 6.
[FIG. 8] FIG. 8 is a schematic diagram illustrating another example of spacing components of the probe according to the second embodiment of the present invention.
[FIG. 9] FIG. 9 is a schematic diagram illustrating a configuration of a probe according to a modified example of the second embodiment of the present invention.
[FIG. 10] FIG. 10 is a schematic diagram illustrating another configuration of a probe according to a modified example of the second embodiment of the present invention.
[FIG. 11] FIG. 11 is a schematic diagram illustrating yet another configuration of a probe according to a modified example of the second embodiment of the present invention.
[FIG. 12] FIG. 12 is a schematic diagram illustrating a probe according to another embodiment of the present invention.
[FIG. 13A] FIG. 13A is a schematic diagram illustrating an example of a pair of beam parts of a probe according to another embodiment of the present invention.
[FIG. 13B] FIG. 13B is a schematic diagram illustrating an example of a pair of beam parts of a probe according to another embodiment of the present invention.
[FIG. 13C] FIG. 13C is a schematic diagram illustrating an example of a pair of beam parts of a probe according to another embodiment of the present invention.
[FIG. 13D] FIG. 13D is a schematic diagram illustrating an example of a pair of beam parts of a probe according to another embodiment of the present invention.
[FIG. 13E] FIG. 13E is a schematic diagram illustrating an example of a pair of beam parts of a probe according to another embodiment of the present invention.
[FIG. 13F] FIG. 13F is a schematic diagram illustrating an example of a pair of beam parts of a probe according to another embodiment of the present invention.
[FIG. 13G] FIG. 13G is a schematic diagram illustrating an example of a pair of beam parts of a probe according to another embodiment of the present invention.
[FIG. 13H] FIG. 13H is a schematic diagram illustrating an example of a pair of beam parts of a probe according to another embodiment of the present invention.
[FIG. 13I] FIG. 13I is a schematic diagram illustrating an example of a pair of beam parts of a probe according to another embodiment of the present invention.
[FIG. 13J] FIG. 13J is a schematic diagram illustrating an example of a pair of beam parts of a probe according to another embodiment of the present invention.

### DESCRIPTION OF EMBODIMENTS

Embodiments of the present invention will be described below with reference to the drawings. The same elements illustrated in the drawings are denoted by the same reference numerals, and overlapping descriptions are not repeated below. The drawings are illustrated schematically, and it should be noted that the proportions of the thicknesses of the respective parts and so forth are not drawn to scale. It should also be understood that the relationships or proportions of the dimensions between the respective drawings can differ from each other. The embodiments described below exemplify a device and a method for embodying the technical idea of the present invention. In the embodiments of the present invention, the material, shape, structure, arrangement, manufacturing method and the like of the components are not limited to the following description.

### (First Embodiment)

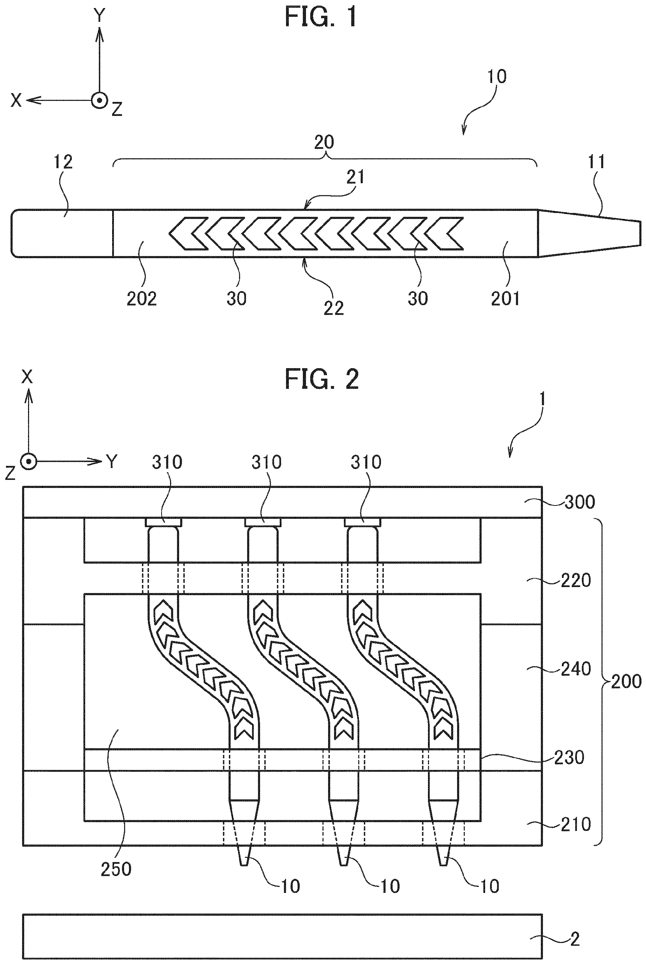

A probe 10 according to a first embodiment of the present invention illustrated in FIG. 1 is used for inspecting the electrical characteristics of an inspection object. The probe 10 includes a first tip 11 and a second tip 12, and a body part 20 connecting the first tip 11 and the second tip 12. The body part 20 includes a first end 201 connected to the first tip 11, a second end 202 connected to the second tip 12, and a columnar first arm 21 and a columnar second arm 22 arranged in parallel and spaced apart from each other between the first end 201 and the second end 202. In addition, the body part 20 includes at least one spacing component 30 that is interposed between the first arm 21 and the second arm 22 so as to maintain the space between the first arm 21 and the second arm 22. The spacing components 30 of the probe 10 illustrated in FIG. 1 bridge the space between the first arm 21 and the second arm 22.

Although the boundaries between the first tip 11 and the second tip 12, and the body part 20 are clearly illustrated in FIG. 1, the first tip 11, the second tip 12, and the body part 20 may be integrally formed. For example, photolithography techniques may be used to manufacture the probe 10. That is, a mask pattern may be formed on the surface of one material, and the probe 10 in which the first tip 11, the second tip 12, and the body 20 are integrated may be manufactured by etching using the mask pattern as an etching mask.

Hereafter, the first arm 21 and the second arm 22 are also collectively referred to as the "arms". In addition, the spacing component 30 which bridges the space between the first arm 21 and the second arm 22 is also referred to as a "bridging part". The bridging part is continuous between the first arm 21 and the second arm 22.

In the probe 10 illustrated in FIG. 1, a plurality of spacing components 30 are arranged spaced apart from each other along the axial direction of the body part 20. Hereafter, the axial direction of the body part 20 is simply referred to as the "axial direction". In addition, the direction in which the first arm 21 and the second arm 22 are arranged is referred to as the "width direction". Furthermore, the direction perpendicular to the axial direction and the width direction is referred to as the "thickness direction". In FIG. 1, the axial direction is illustrated as the X-axis direction, the width direction is illustrated as the Y-axis direction, and the thickness direction is illustrated as the Z-axis direction (the same shall apply in the following description).

The spacing component 30 of the probe 10 illustrated in FIG. 1 is V-shaped when viewed from the thickness direction. That is, the portion of the spacing component 30 that is connected to the arm is connected to the arm at an angle with respect to the axial direction.

In order to describe the function of the probe 10, a probe card including a probe head that holds the probe 10 will be described below.

FIG. 2 illustrates a probe card 1 provided with probes 10. The probe card 1 is used to inspect the characteristics of the inspection object 2. The inspection object 2 is, for example, a semiconductor integrated circuit formed on a semiconductor substrate. The probe card 1 includes a probe head 200 that holds the probes 10 with the first tips 11 facing the inspection object 2, and a wiring board 300. The number of probes 10 held by the probe head 200 can be discretionally set according to the number of terminals of the inspection object 2 or the number of inspection objects 2 to be inspected simultaneously.

The second tip 12 of the probe 10 is connected to a land 310 arranged on the wiring board 300. The land 310 is made of a conductive material such as metal, and an inspection device such as a tester (not illustrated) and the land 310 are electrically connected to each other. An electrical signal propagates between the inspection device and the inspection object 2 via the probe card 1. The wiring board 300 is, for example, a printed circuit board (PCB) or an interposer (IP) board. A highly conductive material such as metal is used for the probe 10 through which the electrical signal propagates.

The probe head 200 has a plurality of guide plates in which through-holes (hereafter also referred to as "guide holes") through which the probes 10 penetrate are formed. The probe head 200 illustrated in FIG. 2 has a bottom guide plate 210 facing the inspection object 2, a top guide plate 220 facing the wiring board 300, and an MGC guide plate 230 arranged between the bottom guide plate 210 and the top guide plate 220. The MGC guide plate 230 is arranged close to the bottom guide plate 210. By arranging a spacer 240 between the outer edge region of the bottom guide plate 210 and the outer edge region of the top guide plate 220, a hollow region 250 is formed inside the probe head 200 between the top guide plate 220 and the MGC guide plate 230. The probe head 200 is made of ceramic, for example.

When viewed from the direction normal to the plane of the main surfaces of the guide plates in which the openings of the guide holes are formed, the position of the guide holes of the top guide plate 220 through which the same probes 10 penetrate and the positions of the guide holes of the bottom guide plate 210 and the MGC guide plate 230 are offset in the direction parallel to the main surface. Since the guide holes are arranged in this way (an offset arrangement), the probes 10 bend in the hollow region 250 due to the elastic deformation. For this reason, the probes 10 buckle when coming into contact with the inspection object 2, and thus the probes 10 come into contact with the inspection object 2 at a prescribed pressure.

The probe card 1 illustrated in FIG. 2 is a vertically-operated probe card, the probe card 1 and the inspection object 2 move along the X-axis direction in a relative manner, and the first tip 11 of the probe 10 comes into contact with the inspection object 2. FIG. 2 illustrates a state in which the probe 10 is not in contact with the inspection object 2. Although FIG. 2 illustrates a case in which the direction in which the body part 20 is curved is the width direction, the direction in which the body part 20 is curved may be the thickness direction.

According to the probe 10 in which the spacing component 30 is interposed between the first arm 21 and the second arm 22, the distance between the first arm 21 and the second arm 22 can be restricted from increasing or decreasing excessively even when the probe 10 is curved.

For example, the probes 10 are prevented from coming into contact with each other in the probe head 200 due to an increase in the distance between the first arm 21 and the second arm 22. In addition, the probe 10 can be prevented from coming into contact with the inner wall surface of the guide hole of the guide plate due to an increase in the distance between the first arm 21 and the second arm 22. Therefore, the damage to the probe 10 and the guide plate caused by contact between the probe 10 and the guide plate can be suppressed.

In contrast, when the distance between the first arm 21 and the second arm 22 decreases excessively, the body part 20 may be plastically deformed, and thus the elasticity of the probe 10 may be lost. However, in the probe 10 in which the space between the first arm 21 and the second arm 22 is maintained by using the spacing component 30, the plastic deformation of the body part 20 can be suppressed.

In addition, by arranging the spacing components 30 between the first arm 21 and the second arm 22, a load applied to the curved probe 10 is caused to concentrate at connection portions of the spacing components 30 that connect with the arms, thereby further enhancing the elasticity of the probe 10. By setting the number of the spacing components 30 and the distance therebetween, the needle pressure of the probe 10 coming in contact with the inspection object can be adjusted.

The number of the spacing components 30 and the distance therebetween can be discretionally set. The number of space portions between the first arm 21 and the second arm 22 increases as the number of the spacing components 30 increases, thereby making it possible to reduce the needle pressure of the probe 10. In contrast, by reducing the number of the spacing components 30, the needle pressure of the probe 10 can be increased. In addition, the distance between the spacing components 30 may be equal, or regions where the distance between the spacing components 30 is long and regions where the distance is short may be present in a mixed manner.

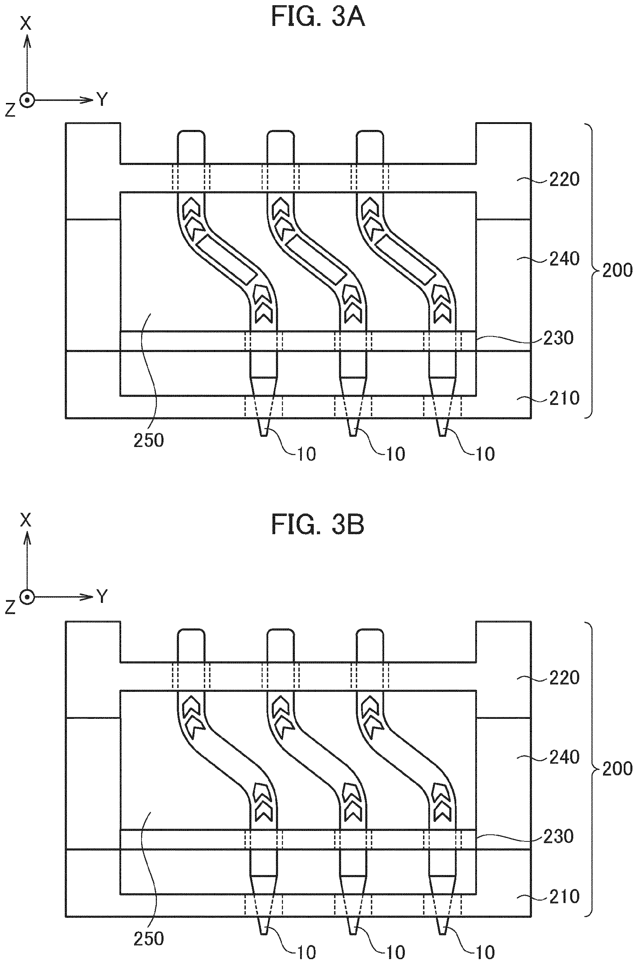

For example, in the probe 10 illustrated in FIG. 3A, the distance between the spacing components 30 increases at the curved portion of the body part 20 to thereby reduce the needle pressure. In the probe 10 illustrated in FIG. 3B, the needle pressure is increased without providing a space between the first arm 21 and the second arm 22 at the curved portion of the body part 20. Thus, the needle pressure of the probe 10 can be adjusted by setting the spaces between the spacing components 30.

Further, the distance between the first arm 21 and the second arm 22 is not increased because the spacing component 30 is provided, thereby making it easier to insert the probe 10 into the through-hole of the guide plate when the probe 10 is attached to the probe head 200.

### <Modified Example>

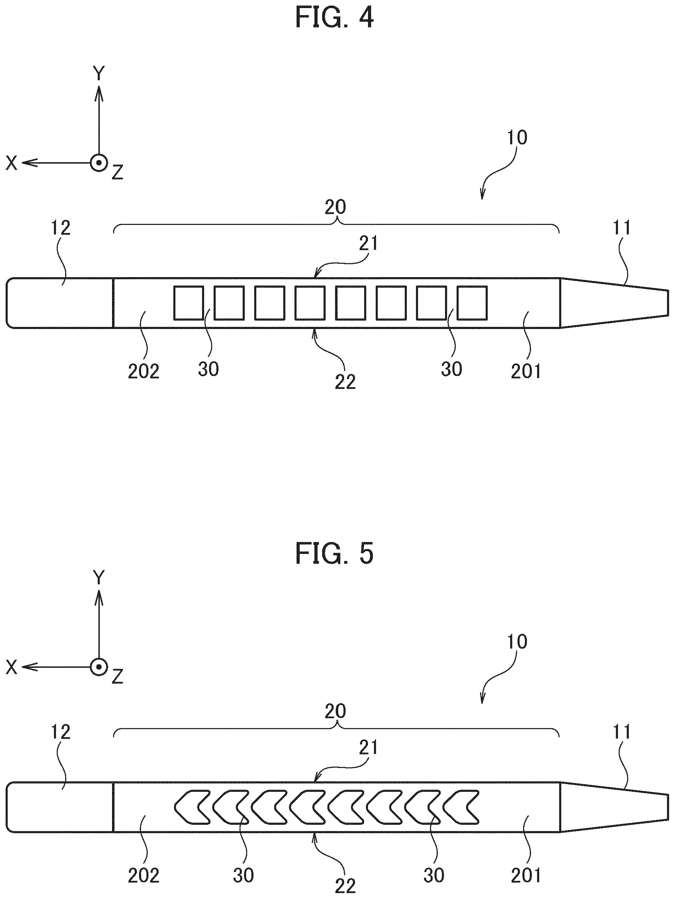

In the probe 10 according to the modified example illustrated in FIG. 4, the rectangular spacing components 30 are arranged perpendicular to the axial direction when viewed from the direction perpendicular to the width direction. For this reason, the shape of the spaces between the first arm 21 and the second arm 22 in between the spacing components 30 is rectangular. Thus, the shape of the spacing components 30 is not limited to a V-shape.

In the probe 10 according to the modified example illustrated in FIG. 5, the spacing components 30 are V-shaped, and the connection portions of the spacing components 30 that connect with the first arm 21 and the second arm 22 are round-chamfered. When the corners of the spacing components 30 are sharply angled, stress is concentrated at the corners of the spacing components 30, and thus the probe 10 is likely to break. The corners of the spacing components 30 are rounded by round-chamfering the connection portions of the spacing components 30 that connect with the arms, and thus stress can be dispersed at the connection portions where stress tends to be concentrated. For this reason, the probe 10 illustrated in FIG. 5, makes it possible to suppress breakage of the probe.

### (Second Embodiment)

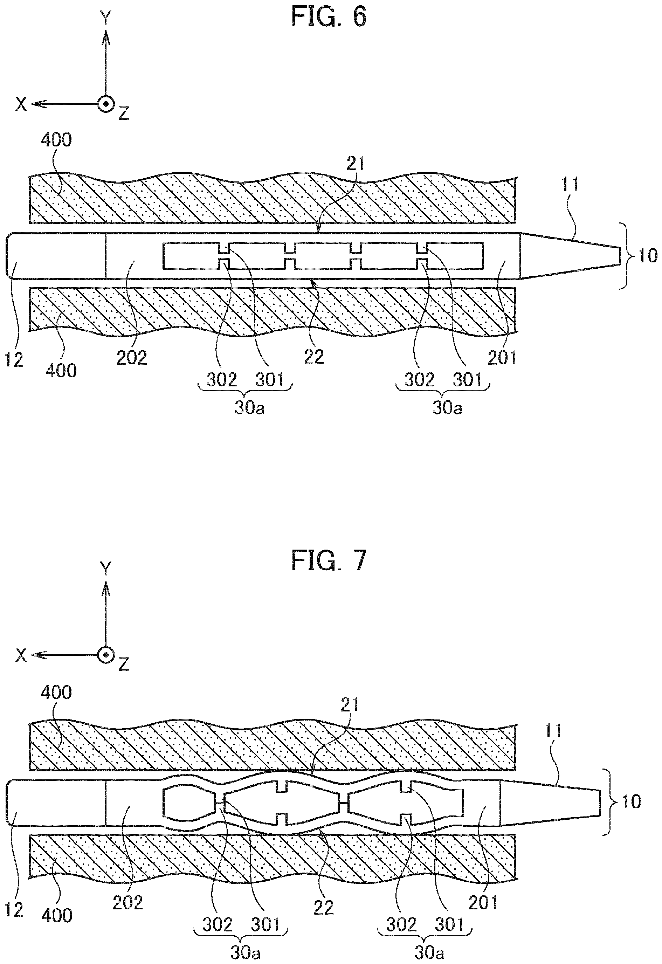

A probe 10 according to a second embodiment of the present invention illustrated in FIG. 6 includes a pair of beam parts 30a that is not continuous between the first arm 21 and the second arm 22, as the spacing component 30. The pair of beam parts 30a has a first beam part 301 and a second beam part 302. The first beam part 301 has a cantilever structure in which one end is connected to the first arm 21 and the other end is a free end. The second beam part 302 has a cantilever structure in which one end is connected to the second arm 22 and the other end is a free end. In a state in which no axial load is applied to the probe 10 (hereafter, also referred to as an "unloaded state"), the free end of the first beam part 301 and the free end of the second beam part 302 are close to each other.

The remaining configuration of the probe 10 illustrated in FIG. 6 is the same as that of the probe 10 in the first embodiment. Although FIG. 6 illustrates a case where the plurality of pairs of beam parts 30a are arranged in the body part 20, only one pair of beam parts 30a may be arranged.

As illustrated in FIG. 6, the probe 10 is arranged inside the through-hole of the support substrate 400 at the time of inspection of the inspection object. In the probe 10 having the pair of beam parts 30a as the spacing component 30, the first arm 21 and the second arm 22 are connected via the spacing component 30 in a state in which the body part 20 is curved due to a load being applied between the first tip 11 and the second tip 12, as will be described later.

In the probe 10 illustrated in FIG. 6, the plurality of pairs of beam parts 30a are spaced apart from each other along the axial direction. In a state in which the body part 20 is curved, at least one pair of beam parts 30a in the plurality of pairs of beam parts 30a is interposed between the first arm 21 and the second arm 22 as the spacing component 30 in which the free end of the first beam part 301 and the free end of the second beam part 302 are in contact with each other. For this reason, a space is formed between the first arm 21 and the second arm 22 in the body part 20 that is axially curved.

FIG. 6 illustrates an unloaded state in which no load is applied between the first tip part 11 and the second tip part 12. The body part 20 is not curved in FIG. 6. In this unloaded state, the pair of beam parts 30a is not continuous between the first arm 21 and the second arm 22.

FIG. 7 illustrates a state in which the probe 10 is in contact with the inspection object (not illustrated) and an axial load is applied between the first tip 11 and the second tip 12. When an axial load is applied, the body part 20 is curved (hereafter, also referred to as a "curved state").

In the curved state, as illustrated in FIG. 7, some portions of the body part 20 increase in the width direction between the first arm 21 and the second arm 22. When some portions of the body part 20 that have increased in the width direction come into contact with the inner wall surface of the through-hole of the support substrate 400, they do not increase further in the width direction. For this reason, a load is applied to the portions of the body part 20 which are not in contact with the inner wall surface of the through-hole, and thus there are some portions in which the space between the first arm 21 and the second arm 22 decreases in the width direction.

At this time, in the probe 10 having the pair of beam parts 30a as the spacing component 30, the first arm 21 and the second arm 22 are connected to each other via the spacing component 30. That is, the first arm 21 and the second arm 22 come close to each other, thereby connecting the free end of the first beam part 301 and the free end of the second beam part 302, and thus the pair of beam parts 30a bridges the space between the first arm 21 and the second arm 22. The pair of beam parts 30a is arranged such that the load is concentrated at the spacing component 30 when the first beam part 301 and the second beam part 302 are connected to each other. Thus, the pair of beam parts 30a is arranged in such a way as to form spaces between the first arm 21 and the second arm 22 in the curved state. For this reason, the probe 10 according to the second embodiment makes it possible to prevent the plastic deformation of the body part 20.

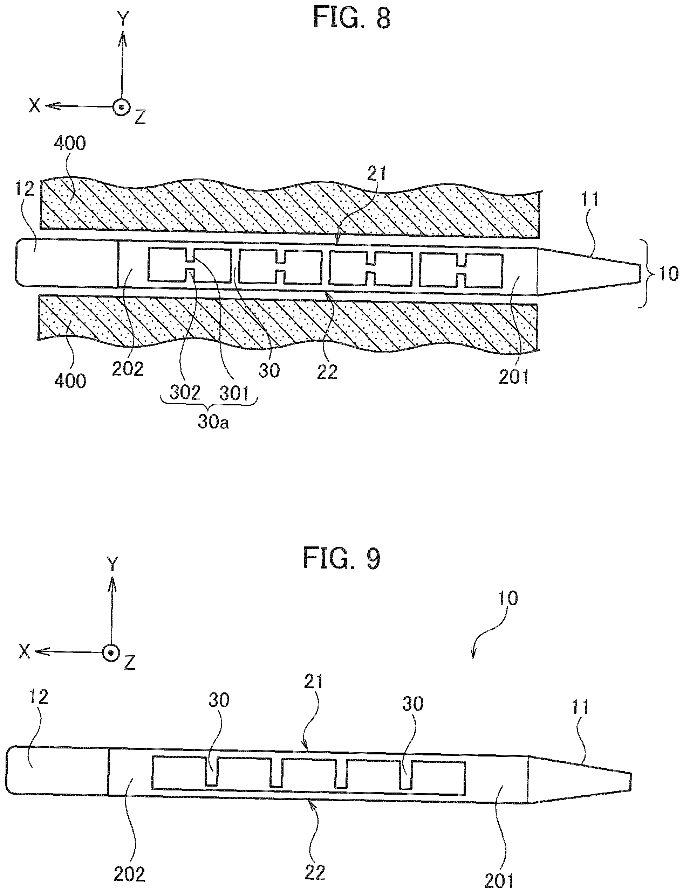

As illustrated in FIG. 6, the body part 20 may be configured of only the plurality of pairs of beam parts 30a as the spacing components 30. Alternatively, as illustrated in FIG. 8, pairs of beam parts 30a and spacing components 30 that are bridging parts may be arranged along the axial direction of the body part 20 in a mixed manner.

Except for the above configuration, the probe 10 of the second embodiment is substantially the same as that of the first embodiment, and the description thereof will be omitted.

### <Modified Example>

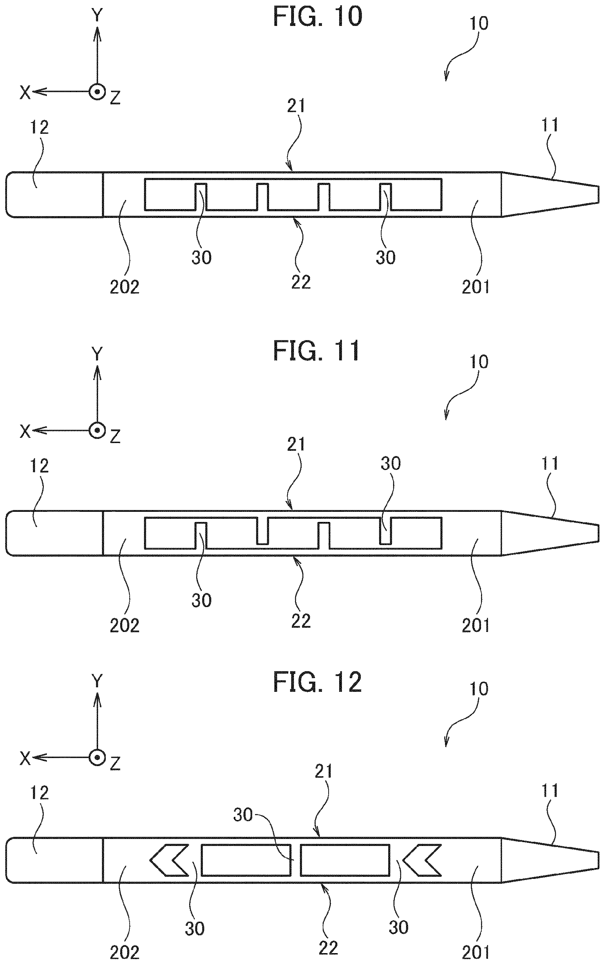

As illustrated in FIG. 9 and FIG. 10, the spacing component 30 may have a cantilever structure in which a fixed end is connected to one of the first arm 21 and the second arm 22 and a free end is close to the other of the first arm 21 and the second arm 22. In FIG. 9, the spacing component 30 is a cantilever structure in which a fixed end is connected to the first arm 21 and a free end is close to the second arm 22. In FIG. 10, the spacing component 30 is a cantilever structure in which a fixed end is connected to the second arm 22 and a free end is close to the second arm 22. As illustrated in FIG. 11, spacing components 30 having a fixed end connected to the first arm 21 and spacing components 30 having a fixed end connected to the second arm 22 may be arranged along the axial direction of the body part 20 in a mixed manner. It is easy to bring the free ends of the spacing components 30 into contact with the arms having a wide area.

### (Other Embodiments)

The embodiments of the present invention have been described above, but the statements and drawings forming part of this disclosure should not be understood as limiting the invention. Various alternative embodiments, examples, and operating techniques will be apparent to those skilled in the art from this disclosure.

For example, although a description has been given regarding the body part 20 including the plurality of spacing components 30 in the above embodiments, the body part 20 may include one spacing component 30. In addition, although a description has been given regarding the probe 10 in which the body part 20 has two arms, the probe 10 may have three or more arms.

Alternatively, the spacing components 30 having different shapes may be arranged along the axial direction as illustrated in FIG. 12.

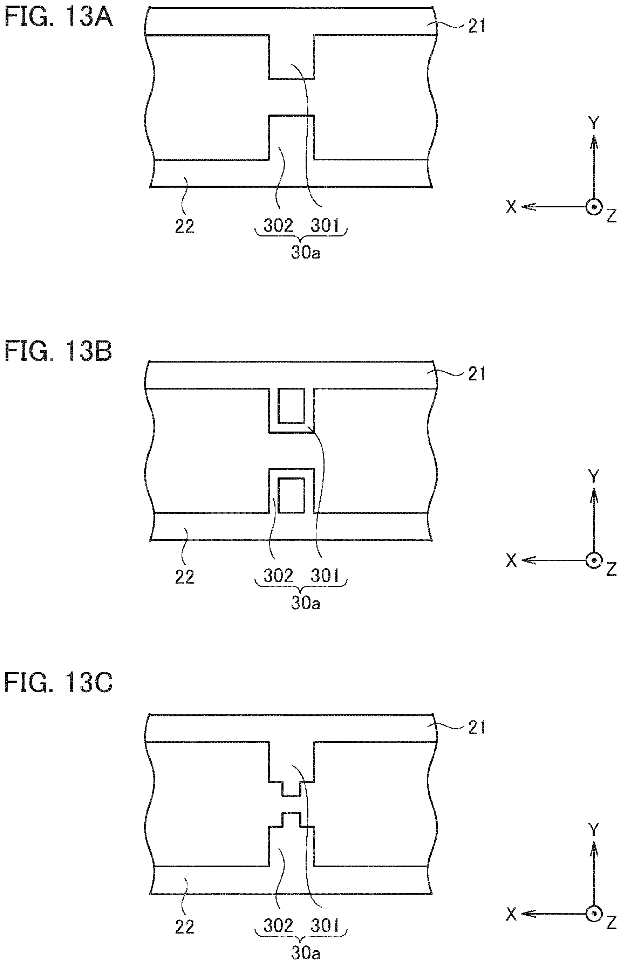

In addition, when the probe 10 has a pair of beam parts 30a as a spacing component 30, various shapes can be adopted for the pair of beam parts 30a as illustrated in FIG. 13A to FIG. 13J, for example. FIG. 13A to FIG. 13J illustrate the shapes of the first beam part 301 and the second beam part 302 forming the pair of beam parts 30a (hereafter, also called a "beam shape") when viewed from the Z-axis direction (hereafter referred to as the "plan view").

As illustrated in FIG. 13A, the beam shape may be rectangular. Alternatively, as illustrated in FIG. 13B, the beam shape may have a frame shape in which the outer shape is rectangular and a space is provided inside the frame shape.

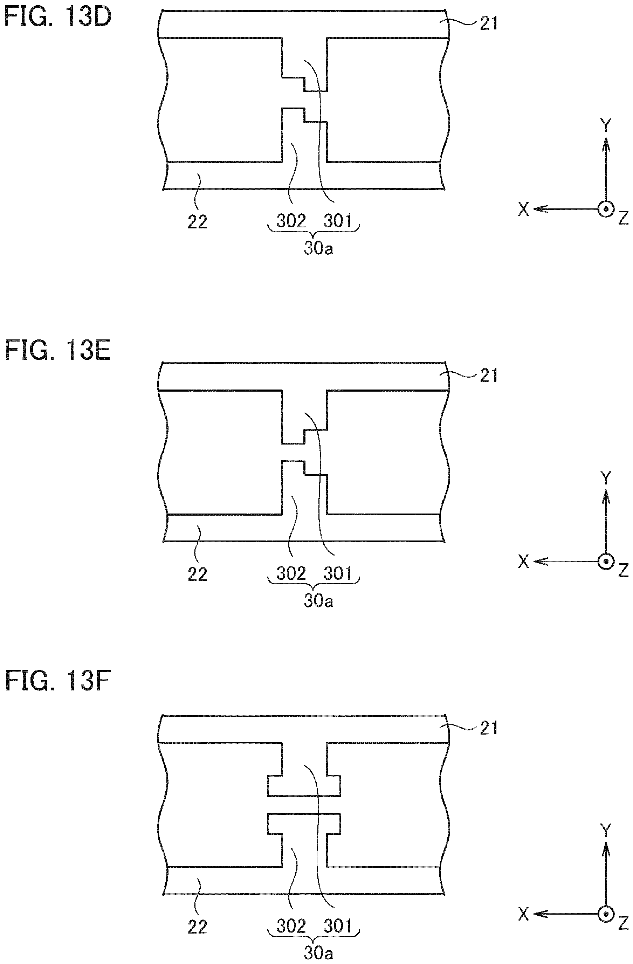

As illustrated in FIG. 13C to FIG. 13F, the beam shape may have a shape in which connection parts and tip parts having different widths in the X-axis direction are connected in the Y-axis direction. The "connection part" is the part where the first beam part 301 and the second beam part 302 are connected to the arms, and the "tip part" is the part that is connected to the connection part and spaced apart from the arms. In the beam shapes illustrated in FIG. 13C to FIG. 13E, the connection parts are wider than the tip parts in the X-axis direction. In the beam shape illustrated in FIG. 13C, the tip part is connected to the center part of the connection part in the X-axis direction when viewed in plan view. In the beam shapes illustrated in FIG. 13D and FIG. 13E, the tip part is connected to the end of the connection part in the X-axis direction when viewed in plan view. In the beam shape illustrated in FIG. 13F, the tip part is wider than the connection part in the X-axis direction.

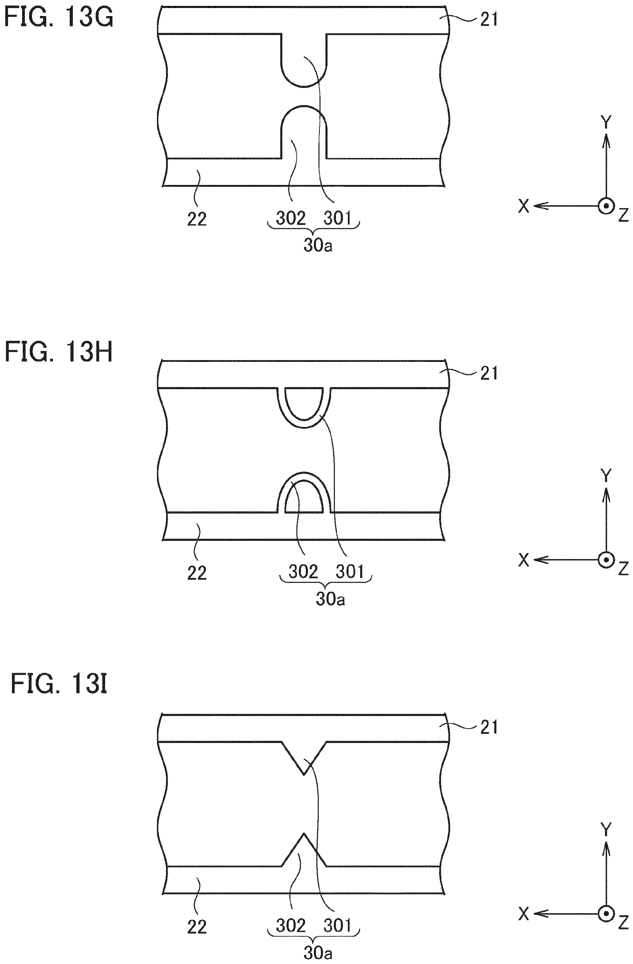

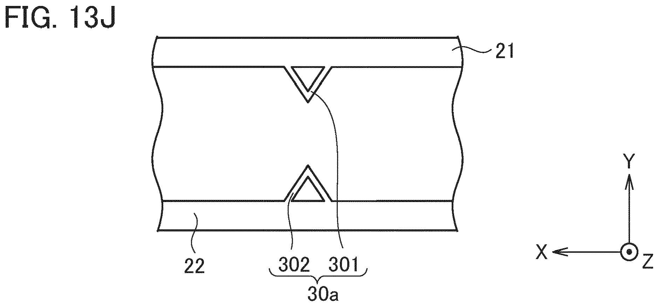

As illustrated in FIG. 13G, the tip part may have a semicircular shape. Alternatively, as illustrated in FIG. 13H, the beam shape may have a frame shape in which the outer shape is semicircular and a space is provided inside the frame shape. In addition, as illustrated in FIG. 13I, the beam shape may have a triangular shape that gradually tapers in the Y-axis direction from the portion connected to the arms. Alternatively, as illustrated in FIG. 13J, the beam shape may have a frame shape in which the outer shape is triangular and a space is provided inside the frame shape.

It should be understood that the present invention includes various embodiments not described herein.

### LIST OF REFERENCE NUMERALS

- 10:: Probe
- 11:: First tip
- 12:: Second tip
- 20:: Body part
- 21:: First arm
- 22:: Second arm
- 30:: Spacing component
- 30a: Pair of beam parts
- 201:: First end
- 202:: Second end
- 301:: First beam part
- 302:: Second beam part

## Claims

1. A probe that is used for inspecting electrical characteristics of an inspection object, comprising:
a first tip and a second tip; and
a body part connecting the first tip and the second tip, wherein
the body part includes:
a first end connected to the first tip;
a second end connected to the second tip;
a columnar first arm and a columnar second arm arranged in parallel and spaced apart from each other between the first end and the second end; and
at least one spacing component that is interposed between the first arm and the second arm.

2. The probe according to claim 1, wherein
the spacing component bridges a space between the first arm and the second arm.

3. The probe according to claim 2, wherein
the spacing component is arranged in plurality, and the spacing components are arranged spaced apart from each other along an axial direction of the body part.

4. The probe according to claim 1, wherein
the spacing component is not continuous between the first arm and the second arm in an unloaded state in which no load is applied between the first tip part and the second tip part, and
the first arm and the second arm are connected to each other via the spacing component in a state in which the body part is curved by a load that is applied between the first tip part and the second tip part.

5. The probe according to claim 4, wherein
the spacing component includes:
a first beam part having one end connected to the first arm and the other end serving as a free end; and
a second beam part having one end connected to the second arm and the other end serving as a free end, and
the free end of the first beam part and the free end of the second beam part come close to each other in the unloaded state.

6. The probe according to claim 4, wherein
the spacing component has a cantilever structure in which a fixed end is connected to one of the first arm and the second arm and a free end is close to the other of the first arm and the second arm.

7. The probe according to any one of claims 4 to 6, wherein
the spacing component is arranged in plurality, and the spacing components are spaced apart from each other along an axial direction of the body part, and in a state in which the body part is curved, at least one of the plurality of the spacing components is interposed between the first arm and the second arm in such a way as to form a space between the first arm and the second arm.

8. The probe according to any one of claims 1 to 7, wherein
the spacing component is V-shaped when viewed from a direction perpendicular to a direction in which the first arm and the second arm are arranged in parallel.

9. The probe according to claim 8, wherein
a connection portion of the spacing component connecting with the first arm and the second arm is round-chamfered.

10. The probe according to any one of claims 1 to 7, wherein
the spacing component is rectangular when viewed from a direction perpendicular to a direction in which the first arm and the second arm are arranged in parallel.
